# EUROPÄISCHE PATENTSCHRIFT

(11) **EP 3 467 446 B1**
(45) Veröffentlichungstag und Bekanntmachung des Hinweises auf die Patenterteilung: **25.09.2019**
(21) Anmeldenummer: 17195212.0
(22) Anmeldetag: 06.10.2017
(51) Int. Cl.: G01S 7/03, H01P 5/08, H01Q 1/22, H03F 3/195, G01F 23/284, G01S 13/38

(54) **RADARFÜLLSTANDMESSGERÄT MIT SYNCHRONISATIONSSIGNAL AUF VERSCHIEDENEN SCHICHTEN EINER PLATINE**
RADAR FILL LEVEL MEASURING DEVICE WITH SYNCHRONIZATION SIGNAL ON DIFFERENT LAYERS OF A BOARD
APPAREIL DE MESURE DE NIVEAU DE REMPLISSAGE À RADAR ET À SIGNAL DE SYNCHRONISATION SUR DIFFÉRENTES COUCHES D'UNE CARTE

(43) Veröffentlichungstag der Anmeldung: 10.04.2019
(73) Patentinhaber: VEGA Grieshaber KG, 77709 Wolfach (DE)
(72) Erfinder: WÄLDE, Steffen, 78078 Niedereschach (DE)
(74) Vertreter: Maiwald Patent- und Rechtsanwaltsgesellschaft mbH

(56) Entgegenhaltungen:
- EP-A1- 3 171 138
- WO-A1-2007/124860
- WO-A1-2014/135452
- WO-A1-2016/202394
- US-A- 5 420 591
- US-A1- 2007 109 178

## Beschreibung

### Gebiet der Erfindung

Die Erfindung betrifft die Füllstandmessung und die Erfassung der Topologie einer Füllgutoberfläche in einem Behälter. Insbesondere betrifft die Erfindung ein Radarfüllstandmessgerät zur Füllstandmessung und/oder zur Erfassung der Topologie einer Füllgutoberfläche in einem Behälter.

### Hintergrund

Zur Füllstandmessung und zur Erfassung der Topologie einer Füllgutoberfläche werden heute Radarfüllstandmessgeräte verwendet. Im Gegensatz zu vielen anderen Bereichen wurde der Durchbruch für die Radartechnik in der Füllstandmessung erst möglich, nachdem extrem kleine Reflexionssignale von der Elektronik der Messgeräte erfasst und verarbeitet werden konnten. Ein solche Radarfüllstandmessgerät ist zum Beispiel in WO 2007/124860 A1 beschrieben.

Moderne Füllstandmessgeräte und Topologiemessgeräte, die in der Lage sind, die genaue Form der Oberfläche eines Füllguts zu erfassen, zeichnen sich nicht nur durch eine hohe Sendefrequenz, die typischerweise im Gigahertzbereich, beispielsweise im Bereich von 75 GHz bis 85 GHz liegt, aus, sondern sind auch in der Lage, Amplitudenunterschiede des reflektierten Signals in einem Bereich bis zu 100 dB sicher zu verarbeiten.

Zur Erzeugung und Verarbeitung der hochfrequenten Sendesignale im Bereich von 79 GHz kann ein monolithisch aufgebauter integrierter Mikrowellenschaltkreis (MMIC) vorgesehen sein. Dieser Baustein kann eine Vielzahl an Sende- und Empfangskanälen aufweisen, die in dieser Anmeldung auch als Radarkanäle bezeichnet werden, so dass die Füllgutoberfläche abgescannt werden kann.

Je genauer die Füllgutoberfläche abgescannt werden soll, desto mehr Sende- und Empfangskanäle sind erforderlich, um eine hochqualitative Abbildung zu erzielen, was mit entsprechend hohem Hardwareaufwand und Energiebedarf einhergeht.

### Zusammenfassung der Erfindung

Es ist eine Aufgabe der Erfindung, ein Radarfüllstandmessgerät zum Messen eines Füllstands eines Mediums oder der Topologie eines Mediums in einem Behälter bereitzustellen.

Diese Aufgabe wird durch den Gegenstand des unabhängigen Patentanspruchs gelöst. Weiterbildungen der Erfindung ergeben sich aus den Unteransprüchen und der folgenden Beschreibung.

Ein erster Aspekt der Erfindung betrifft ein Radarfüllstandmessgerät, das zur Messung eines Füllstands eines Mediums in einem Behälter und/oder zur Erfassung der Topologie einer Füllgutoberfläche in dem Behälter eingerichtet ist. Das Radarfüllstandmessgerät weist eine Platine oder Leiterplatte mit einer ersten Schicht (Layer) und einer zweiten Schicht auf, sowie einen ersten Radarchip und einen zweiten Radarchip, die jeweils auf der ersten Schicht angeordnet sind.

Sowohl der erste Radarchip als auch der zweite Radarchip können einen oder mehrere Sendekanäle zum Abstrahlen jeweils eines Sendesignals in Richtung der Füllgutoberfläche und einen oder mehrere Empfangskanäle zum Empfangen der an der Füllgutoberfläche reflektierten Sendesignale aufweisen. Einer oder mehrere der Sendekanäle kann auch als kombinierter Sende-Empfangskanal ausgeführt sein.

Die Radarchips können insbesondere integrierte Mikrowellenschaltkreise sein, welche auch als Radarsystem on Chip bezeichnet werden können. Ein solches Radarsystem on Chip (RSoC) ist ein hochintegrierter Mikrowellenschaltkreis mit Schaltungskomponenten für digitale Funktionen, welches, gemäß einer Ausführungsform, in der Lage ist, die komplette Funktionalität eines herkömmlichen Radarsystems für die Signalerzeugung, die Signalverarbeitung und die Überführung der Empfangssignale, also der reflektierten Sendesignale, in digitale Darstellung auf einem einzigen Radarchip zu integrieren.

Jeder der Sendekanäle kann eingerichtet sein, ein hochfrequentes Sendesignal mit einer Frequenz im zwei- oder dreistelligen Gigahertzbereich zu erzeugen, beispielsweise im Bereich von 75 GHz bis 85 GHz.

Der erste Radarchip weist eine erste Synchronisationsschaltung auf, welche zur Erzeugung eines Hochfrequenzsignals eingerichtet ist, bei dem es sich im Regelfall um ein Lokaloszillatorsignal des Radarchips handelt. Bei dem Hochfrequenzsignal kann es sich beispielsweise um ein frequenzgeteiltes Signal handeln, das somit eine geringere Frequenz aufweist als das vom Radarfüllstandmessgerät abgestrahlte Sendesignal. Beispielsweise weist das Hochfrequenzsignal eine Frequenz von 40 GHz oder 20 GHz auf.

Der zweite Radarchip weist eine zweite Synchronisationsschaltung auf und es ist eine Hochfrequenzleitungsanordnung vorgesehen, die eingerichtet ist zur Übertragung des Hochfrequenzsignals von der ersten Synchronisationsschaltung an die zweite Synchronisationsschaltung, und welches zur Synchronisation der beiden Radarchips vorgesehen ist. Durch die Frequenzteilung des Hochfrequenzsignals kann die Leiterbahnführung vereinfacht werden, da die Verlustleistung sinkt. Es kann vorgesehen sein, dass das Hochfrequenzsignal wieder vervielfacht wird, bevor es zur Synchronisation der beiden Radarchips eingesetzt wird, beispielsweise durch einen in der zweiten Synchronisationsschaltung angeordneten Frequenzvervielfacher.

Die Hochfrequenzleitungsanordnung weist eine erste Leiterbahn auf der ersten Schicht, eine zweite Leiterbahn auf der ersten Schicht und eine dazwischen angeordnete Hochfrequenzleitung auf der zweiten Schicht auf, die über jeweils ein Via mit der ersten und der zweiten Leiterbahn verbunden ist.

Gemäß einer Ausführungsform der Erfindung weist die eine dritte Leiterbahn auf.

Gemäß einer Ausführungsform der Erfindung weist die Hochfrequenzleitung einen Hohlleiter auf.

Gemäß einer Ausführungsform der Erfindung ist die erste Leiterbahn, die zweite Leiterbahn und/oder dritte Leiterbahn eine Mikrostreifenleitung oder umfasst zumindest eine solche.

Die Hochfrequenzleitungsanordnung zur Übertragung des Hochfrequenzsignals kann einen, zwei oder mehr unterschiedliche Leistungstypen aufweisen, die zumindest teilweise seriell zueinander angeordnet sind.

Beispielsweise weist die Hochfrequenzleitungsanordnung eine Mikrostreifenleitung auf, sowie einen Hohlleiter, beispielsweise einen Rechteckhohlleiter oder einen Rundhohlleiter, einen Koaxialleiter, einen im Substrat integrierten Hohlleiter (Substrate Integrated Waveguide, SIW) und/oder eine Koplanarleitung. Auch können andere planare Leitungstypen vorgesehen sein.

Durch den Wechsel von einem Leitungstyp auf einen anderen Leitungstyp kann die Verlustleistung weiter reduziert werden, weil der zweite Leitungstyp das Hochfrequenzsignal weniger stark dämpft.

Die Hochfrequenzleitungsanordnung kann darüber hinaus eine Hohlleitereinkopplung zum Einkoppeln des Hochfrequenzsignals von dem ersten Leitungstyp in einen Hohlleiter (zweiter Leitungstyp) aufweisen.

Beispielsweise ist die Hochfrequenzleitungsanordnung mithilfe eines oder mehrerer Hochfrequenzleistungsteiler aufgesplittet, um mehrere Radarchips zu synchronisieren.

Es kann vorgesehen sein, dass die beiden von dem Hochfrequenzleistungsteiler ausgehenden Leitungen, die zur zweiten Synchronisationsschaltung zweier weiterer Radarchips führen, dieselbe Signallaufzeit aufweisen, welche das gesplittete Hochfrequenzsignal benötigt, die entsprechende Synchronisationsschaltung des entsprechenden Radarchips zu erreichen.

Des Weiteren kann ein Hochfrequenzverstärker (oder mehrere davon) vorgesehen sein, der in der Hochfrequenzleitungsanordnung angeordnet ist und eingerichtet ist zur Verstärkung des Hochfrequenzsignals.

Der erste Radarchip kann als sogenannter Masterchip ausgeführt sein, der ein Synchronisationssignal erzeugt, mit dessen Hilfe der oder die weiteren Radarchips, der/die als Slavechips bezeichnet werden, synchronisiert werden.

Gemäß einer weiteren Ausführungsform der Erfindung ist das Hochfrequenzsignal im Verhältnis zum Sendesignal ein um einen ganzzahligen Faktor geteiltes Hochfrequenzsignal.

Es kann vorgesehen sein, dass die Verstärkerleistung des oder der in der Hochfrequenzleitungsanordnung angeordneten Hochfrequenzverstärker in Abhängigkeit vom Füllstand eingestellt wird, und/oder beispielsweise in Abhängigkeit davon, wie viele Radarchips momentan für die Füllstandmessung verwendet werden.

Gemäß einer weiteren Ausführungsform der Erfindung weist der Hochfrequenzverstärker einen Nutzfrequenzbereich von 30 GHz auf, oder von 60 GHz.

Gemäß einer weiteren Ausführungsform der Erfindung ist auf dem ersten und/oder dem zweiten Radarchip jeweils ein Analog-Digital-Wandler integriert, eingerichtet zum Umwandeln des Empfangssignals in ein digitalisiertes Zwischenfrequenzsignal, welches auf ein oder mehrere an der Füllgutoberfläche reflektierte Sendesignale zurückzuführen ist.

Gemäß einer weiteren Ausführungsform der Erfindung weisen zumindest zwei der Sendekanäle jeweils eine Antenne auf, die daran angeschlossen ist.

Gemäß einer weiteren Ausführungsform der Erfindung ist das Radarfüllstandmessgerät als FMCW-Radarfüllstandmessgerät ausgeführt, das ein frequenzmoduliertes Dauerstrichsignal zur Messung verwendet, wobei jeder Messzyklus mindestens einen Frequenzsweep umfasst, der beispielsweise eine Startfrequenz von 75 GHz aufweist und eine Maximalfrequenz von 85 GHz.

Gemäß einer weiteren Ausführungsform weist die Hochfrequenzleitungsanordnung eine erste Leiterbahn auf einer Platine, eine zweite Leiterbahn auf der Platine und einen dazwischen angeordneten Hohlleiter auf.

Die Hochfrequenzleitungsanordnung kann darüber hinaus Vias aufweisen, welche durch die Platine geführt sind und dazu dienen, die Platinenoberseite zu wechseln, so dass Teile der Hochfrequenzleitungsanordnung auf der einen Seite der Platine angebracht sind, und andere Teile der Hochfrequenzleitungsanordnung auf der gegenüberliegenden, anderen Seite.

Gemäß einer weiteren Ausführungsform der Erfindung ist das Radarfüllstandmessgerät zur Erfassung der Topologie eines Mediums in einem Behälter eingerichtet.

Gemäß einer weiteren Ausführungsform der Erfindung basiert der erste und der zweite Radarchip jeweils auf BiCMOS-Technologie. Gemäß einer weiteren Ausführungsform der Erfindung basieren die Radarchips auf SiGe-Technologie. Gemäß einer weiteren Ausführungsform der Erfindung basieren die Radarchips auf HF-CMOS-Technologie und weisen Hochfrequenzschaltungsteile für Frequenzen von 75 GHz und darüber auf.

Gemäß einer weiteren Ausführungsform der Erfindung handelt es sich bei dem Hochfrequenzverstärker um einen rauscharmen Verstärker (Low Noise Amplifier, LNA) mit separater Spannungsversorgung.

Gemäß einer Ausführungsform der Erfindung wird der Hochfrequenzverstärker ausschließlich in seinem linearen Bereich betrieben. Gegebenenfalls können mehrere Hochfrequenzverstärker in der Hochfrequenzleitungsanordnung vorgesehen sein.

Im Folgenden werden mit Verweis auf die Figuren Ausführungsformen der Erfindung beschrieben. Werden in der folgenden Figurenbeschreibung dieselben Bezugszeichen verwendet, so bezeichnen diese gleiche oder ähnliche Elemente. Die Darstellungen in den Figuren sind schematisch und nicht maßstäblich.

### Kurze Beschreibung der Figuren

Fig. 1A zeigt ein Radarfüllstandmessgerät, das in einem Behälter installiert ist, um die Topologie der Oberfläche eines Füllguts in dem Behälter zu erfassen.
Fig. 1B zeigt ein weiteres Radarfüllstandmessgerät.
Fig. 1C zeigt ein weiteres Radarfüllstandmessgerät.
Fig. 2 zeigt eine Array-Antenne eines Radarfüllstandmessgeräts.
Fig. 3 zeigt den Aufbau eines Radarfüllstandmessgeräts mit einem Radarchip.
Fig. 4A zeigt den Aufbau eines weiteren Radarfüllstandmessgeräts mit zwei Radarchips.
Fig. 4B zeigt den Aufbau eines weiteren Radarfüllstandmessgeräts.
Fig. 5 zeigt den Aufbau eines weiteren Radarfüllstandmessgeräts.
Fig. 6 zeigt den Aufbau eines weiteren Radarfüllstandmessgeräts.
Fig. 7 zeigt den Aufbau eines weiteren Radarfüllstandmessgeräts.
Fig. 8 zeigt einen Platinenlagenaufbau.
Fig. 9A zeigt eine Via-Anordnung eines Radarfüllstandmessgeräts.
Fig. 9B zeigt die metallisierten Elemente der Via-Anordnung der Fig. 9A.
Fig. 10A zeigt einen Ausschnitt einer Hochfrequenzleitungsanordnung.
Fig. 10B zeigt einen Ausschnitt einer weiteren Hochfrequenzleitungsanordnung.
Fig. 10C zeigt einen Ausschnitt einer weiteren Hochfrequenzleitungsanordnung.
Fig. 11 zeigt eine weitere Hochfrequenzleitungsanordnung mit Hohlleiter.

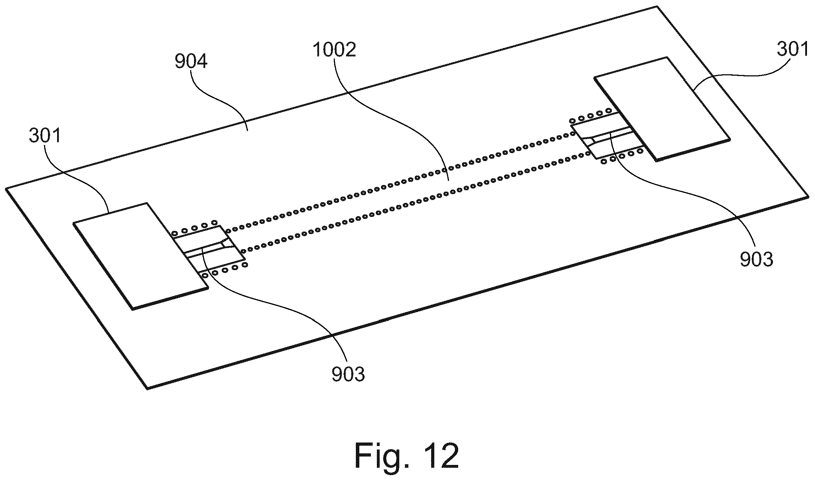

Fig. 12 zeigt eine weitere Hochfrequenzleitungsanordnung.
Fig. 13A zeigt die Draufsicht auf eine weitere Hochfrequenzleitungsanordnung.
Fig. 13B zeigt die Unterseite einer Platine der Leitungsanordnung der Fig. 13A.
Fig. 14A zeigt eine weitere Hochfrequenzleitungsanordnung mit Hohlleiter und Leistungsteiler.
Fig. 14B zeigt eine weitere Hochfrequenzleitungsanordnung mit Hohlleiter, Leistungsteiler und Verstärker.
Fig. 15A zeigt eine weitere Hochfrequenzleitungsanordnung mit Leistungsteiler.
Fig. 15B zeigt eine weitere Hochfrequenzleitungsanordnung mit Hohlleiter, Leistungsteiler und Verstärker.
Fig. 15C zeigt die Unterseite der Hochfrequenzleitungsanordnungen der Fig. 15A und Fig. 15B.

### Detaillierte Beschreibung von Ausführungsformen

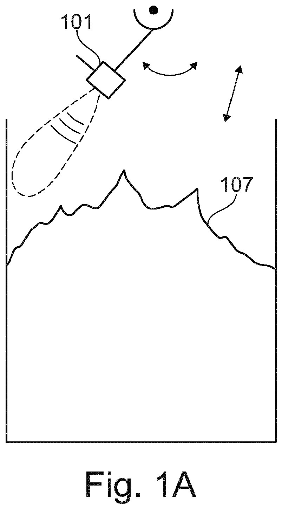

Fig. 1A zeigt ein Radarfüllstandmessgerät 101, das in einem Behälter installiert ist, um die Topologie der Oberfläche eines Füllguts in dem Behälter zu erfassen.

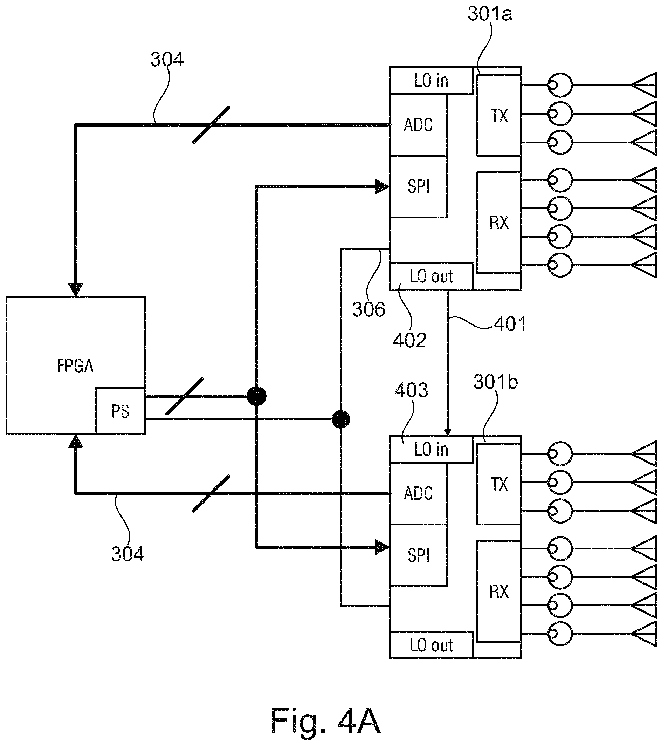

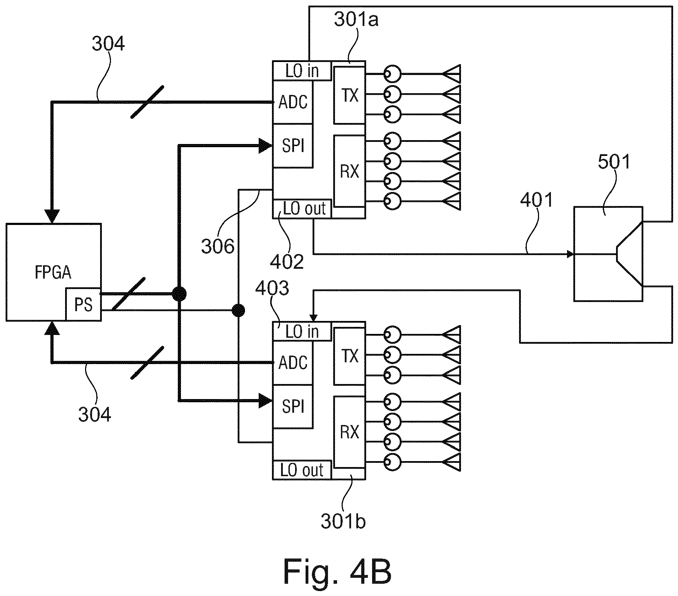

Das Radarfüllstandmessgerät weist mehrere hochintegrierte Radarchips (RSoCs, Radar System on Chips) 301 auf, siehe beispielsweise Fig. 4A, die mehrere Sender und Empfänger aufweisen. Diese können auch in Bereichen wie Fahrerassistenzsystemen, Verkehrsüberwachung, Objektüberwachung in Industriebetrieben, Drohnen und vielen weiteren Bereichen eingesetzt werden. Ein Vorteil von mehrkanaligen Radarchips 301 ist es, dass eine Art von Strahlformung durchgeführt werden kann. Die üblichen Radargeräte für obige Anwendungen benötigen teilweise ein bis vier Radarchips 301, um den Anforderungen gerecht zu werden.

Auch in der Füllstandmessung finden sich für diese RSoCs 301 Einsatzgebiete. So zeigt Fig. 1A ein die Topologie einer Füllgutoberfläche erfassendes Füllstandmessgerät 101, das die Oberfläche von Schüttgütern abtastet, um dadurch mehr Informationen über den tatsächlichen Füllstand und dessen Volumen zu erhalten, als man sie bei einer klassischen Füllstandmessung erhalten würde.
Eine Herausforderung hierbei ist es, dass auch in großer Distanz noch kleine Öffnungswinkel benötigt werden, was mit einer großen Antennenapertur einhergeht.

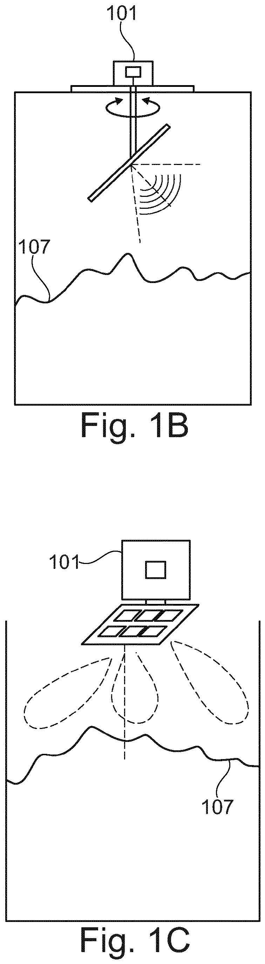

Eine Möglichkeit dies zu erreichen, ist es ein Ein-Kanal-Radargerät mechanisch zu schwenken (Figur 1A), um so die Oberfläche abzutasten. Eine weitere Möglichkeit ist der Einsatz bereits teilmechanischer Systeme (Figur 1B). Dort wird eine Kombination aus analoger oder digitaler Strahlformung mit einem mechanischen Schwenken kombiniert. Nachteile haben diese Systeme hinsichtlich Robustheit. Mechanische Komponenten sind in rauen Prozessbedingungen wartungsanfällig und in der Herstellung teuer. Deshalb gibt es die Möglichkeit eine vollelektronische Strahlformung durchzuführen (Figur 1C).

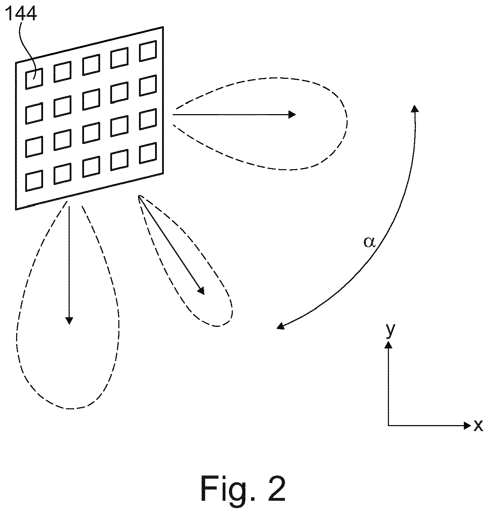

Um mit diesen Beamforming-Radarsystemen vergleichbar große Antennenaperturen zu erreichen, muss eine große Anzahl an Sendern und Empfängern vorgesehen werden. Der Nachteil an der vollelektronischen Strahlformung ist, dass viele Antennen mit verhältnismäßig kleiner Einzelapertur verwendet werden müssen. Außerdem müssen Sender und Empfänger, die üblicherweise mit jeweils einem Antennenelement 144, 303 versehen werden, in zwei Dimensionen (x- und y-Richtung) aufgereiht werden (Figur 2).

Für die topologieerfassende Füllstandmesstechnik werden deshalb üblicherweise mehr Sender und Empfänger als in anderen Anwendungen benötigt, was in einer Chipanzahl größer vier resultieren kann.

Die topologieerfassenden Radarfüllstandmessgeräte weisen meist mehrere Sende- und Empfangsantennen auf. Diese Systeme werden auch als MIMO-Systeme (Multiple Input Multiple Output) bezeichnet. Durch bestimmte Verfahren der digitalen Strahlformung können sowohl sende- als auch empfangsseitig die Richtcharakterisika der Sende- und Empfangsgruppenantenne digital beeinflusst werden, wodurch die Abtastung einer Füllgutoberfläche realisiert werden kann. Diese Füllstandmessgeräte verwenden bisher für jeden Sende- und Empfangskanal mehrere diskrete Hochfrequenzbauelemente, wie Mischer, Low Noise Amplifier, Koppler, Frequenzvervielfacher, spannungsgesteuerte Oszillatoren etc. sowie diskrete Analog-/Digitalwandler, Phasenregelschleifen, Spannungsregler, Filter, Verstärker und weitere Niederfrequenzbauelemente. Diese Eigenschaft kann die MIMO-Systeme aufwändig, groß und teuer machen.

Neue hochintegrierte Radarchips 301 haben viele dieser oben genannten Komponenten bereits vollständig auf einem Chip 301 integriert. Bereits integriert sind: PLL, VCO, Mischer, ADCs, Filter, Steuerungseinheiten, SPI Schnittstelle, Verstärker, Schalter, Spannungsregler. Dadurch kann viel Platz auf einer Leiterkarte gespart werden. Ein weiterer Vorteil bieten diese Chips 301 hinsichtlich Kosten, da diese günstiger sind als ein diskreter Aufbau mit mehreren verschiedenen Einzelkomponenten. Die MIMO-Chips 301 haben beispielsweise drei Sender- und vier Empfängerstufen. Ein möglicher Sendefrequenzbereich kann beispielsweise zwischen 55 und 65 GHz oder aber auch zwischen 75 und 85GHz liegen.

Die Radarchips 301 können über eine digitale Schnittstelle (mit zugehörigem Bus 305) (SPI, I²C, etc.) parametriert werden. Es können verschiedene Parameter gesetzt oder ausgelesen werden um die Modulationsart, Bandbreite, Frequenzbereich, Abtastfrequenz, ZF-Filtercharakteristika (Zwischenfrequenzsignal), etc. einzustellen.

Üblicherweise werden die analogen ZF-Signale, die Informationen über Abstände und Winkel von Objekten aus dem Überwachungsbereich beinhalten, ebenfalls noch auf dem Radarchip 301 für die weitere Signalverarbeitung digitalisiert.

Das Radarverfahren nach dem diese Radarchips 301 üblicherweise arbeiten ist ein spezielles frequenzmoduliertes Dauerstrichradarverfahren (FMCW-Verfahren, frequency modulated continous wave). Es wird bei einer Messung jedoch nicht nur eine Frequenzrampe moduliert sondern mehrere hintereinander, die in einem festen Zeitbezug zueinander stehen. Eine mögliche Anzahl an Rampen pro Messung ist beispielsweise 128. Diese 128 Rampen zusammengefasst werden als Frame bezeichnet.

Durch geschickte Signalverarbeitungsalgorithmen lassen sich neben Abständen auch Geschwindigkeiten von mehreren Objekten bestimmen. Die Rampendauer ist im Verhältnis zum klassischen FMCW-Verfahren sehr kurz und liegt üblicherweise im Bereich zwischen 10 und 500µs pro Rampe. Da die HF-Bandbreite der Sendesignale im Bereich zwischen mehreren Hundert Megahertz und vier (oder mehr) Gigahertz liegen kann, sollte das Zwischenfrequenzsignal mit hoher Abtastrate digitalisiert werden.

Die Kombination aus hoher HF-Bandbreite und kurzen Rampendauern, resultiert in einer hohen Abtastrate bei der Analog-Digital-Wandlung.

Die Schnittstelle für die digitalisierten Ausgangssignale ist meist eine schnelle serielle, differentielle Digitalschnittstelle 304 wie LVDS oder CSI2. Beim Beispiel eines Radarchips 301 mit vier Empfangskanälen weist der Radarchip 301 seitens der Digitalschnittstelle vier LVDS- bzw. CSI2-Schnittstellen auf, über die das digitalisierte Zwischenfrequenzsignal übertragen wird. Zusätzlich verwenden diese Digitalschnittstellen ein zusätzliches differentielles Clock-Signal, das beim Empfänger der digitalisierten Daten zur Synchronisation der Schnittstellen benötigt wird. Je nach Schnittstelle werden noch weitere Signalleitungen benötigt um Anfang und/oder Ende der Datenpakete zu kennzeichnen.

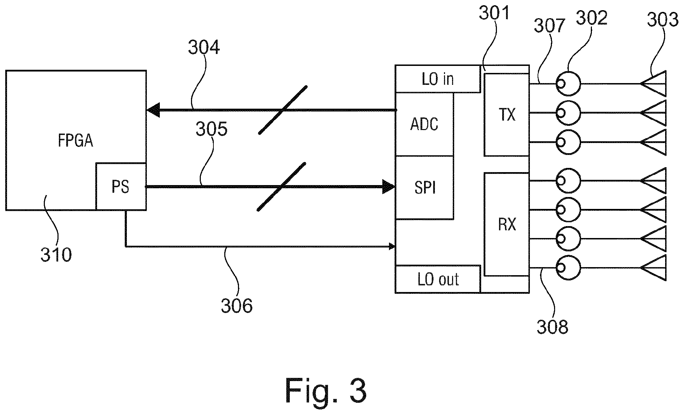

Für den Fall, dass der Radarchip 301 für die gewünschte Applikation dennoch zu wenig Sende- und Empfangskanäle 307 (Fig. 3) liefert, bieten diese Chips (301) die Möglichkeit einer Kaskadierung. Das bedeutet, dass mehrere Chips zu einer synchronisierten Radareinheit zusammengefasst werden. Somit wird es möglich, Sender gleichzeitig mit einem synchronen Signal senden zu lassen und/oder Empfänger synchron empfangen zu lassen, obwohl diese sich physikalisch auf unterschiedlichen RSoCs befinden.

Das wird möglich, indem neben verschiedenen Taktsynchronisationsleitungen ebenfalls ein Hochfrequenzsignal auf einer Hochfrequenzleitungsanordnung 401 ausgehend von einer Synchronisationsschaltung 402 eines ersten Chips 301a an die Synchronisationsschaltungen 403 anderer Chips 301b verteilt wird. Das Hochfrequenzsignal wird als Lokaloszillatorsignal (LO-Signal) bezeichnet und ist vom Frequenzbereich her in Bezug auf den Sendefrequenzbereich um einen ganzzahligen Faktor geteiltes Signal. Möglich sind die Teilerfaktoren zwei oder vier aber auch andere ganzzahlige Teilerfaktoren. Hat der Radarchip beispielsweise einen Sendefrequenzbereich um 80 GHz, so kann das LO-Signal einen Frequenzbereich um 20 GHz oder 40 GHz umfassen.

Der Chip, der das Hochfrequenzsignal bereitstellt, wird als Master 301a bezeichnet. Die Chips, die das Hochfrequenzsignal empfangen, werden als Slaves 301b bezeichnet.

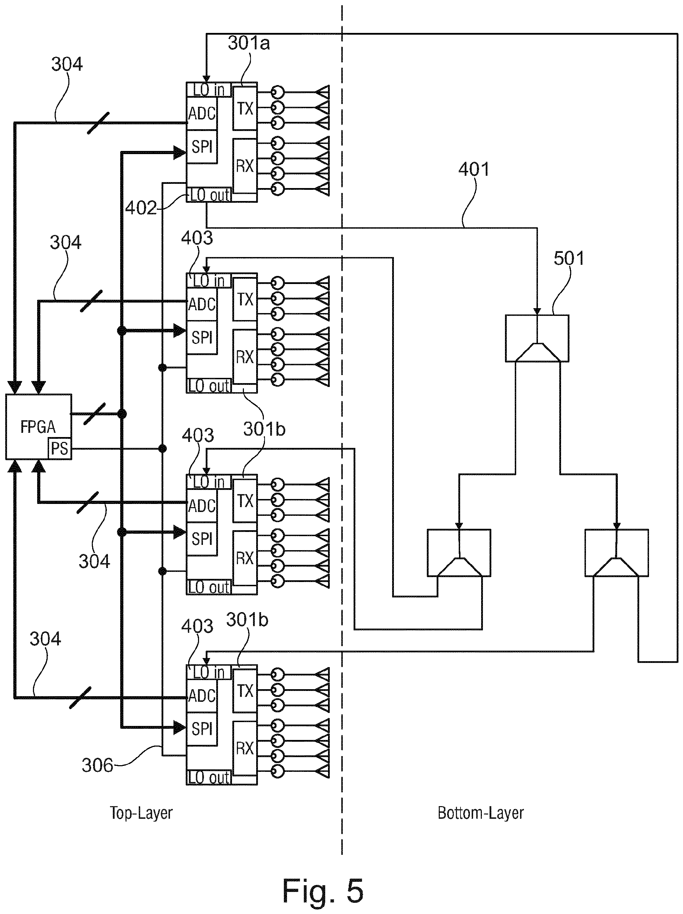

Beispielsweise hat ein kaskadiertes Radarsystem, das vier Radarchips beinhaltet (Figur 5), die wiederum jeweils vier Empfangskanäle aufweisen, sechzehn Digitalschnittstellen über die die zugehörigen Zwischenfrequenzsignale (Messdaten) übertragen werden.

Die Radarchips verwenden zur Verarbeitung dieser digitalen Messdaten meist speziell angepasste Signalprozessoren, die jedoch eine stark begrenzte Anzahl von Digitalschnittstellen aufweisen. Auf dem Radarchip selbst können Einheiten zur digitalen Signalverarbeitung integriert sein, was aber für eine Kaskadierung von Radarchips und im Kontext der radarbasierten, topologiebestimmenden Füllstandmessung nur begrenzt nützlich ist oder gar nicht verwendet werden kann.

Deshalb wird zur Umgehung dieses Problems vorgeschlagen, anstelle dem speziell angepassten Signalprozessor einen FPGA Baustein (Field Programmable Gate Array) zu verwenden (Figuren 3, 4A, 4B und 5). Diese universell einsetzbaren Bausteine, sind von einigen wenigen Herstellern in verschiedenen Ausführungsformen erhältlich. Das FPGA empfängt die digitalisierten Werte des Zwischenfrequenzsignals und übernimmt Rechenoperationen wie Mittelung, Fensterung oder die Berechnung von FFTs (Fast Fourier Transformation). Vorteilhaft an der Kombination aus Radarchips und FPGA ist eine flexible Kombination von acht oder mehr Radarchips, die mit einem speziell angepassten Signalprozessor, wie er in der Automobilindustrie verwendet wird nicht möglich wäre. Durch die Kaskadierung einer solch großen Anzahl von Radarchips wird diese Technologie für die Füllstandmesstechnik interessant.

Wird eine weit größere Anzahl an Radarchips benötigt, ist es denkbar ebenfalls mehrere FPGAs zu verwenden und diese dann ebenfalls untereinander zu synchronisieren.

In vorteilhafter Weise beinhaltet das FPGA neben den programmierbaren Logikzellen ein integriertes Prozessorsystem (PS) das Steuerungsaufgaben, wie die Parametrierung der Radarchips, das Energiemanagement, die Ansteuerung eines Displays oder die Kommunikation mit einem Computer oder einer Prozessleitstelle über ein Netzwerk übernehmen kann. Ebenfalls kann das Prozessorsystem über eine Digitalleitung 306 den Start einer Messung signalisieren.

Weiterhin kann das Prozessorsystem Signalverarbeitungsaufgaben wie sie aus bestehenden Füllstandradarmessgeräten bekannt sind, wie Echosuche, Störechoausblendung, etc. übernehmen.

Je nach Art des Radarchips und des FPGAs kann es notwendig sein, eine Pegelanpassung der Digitalschnittstellen vorzunehmen. Hierfür kann ein speziell angepasstes Widerstandsnetzwerk oder ein Anpassungschip verwendet werden.

Da die Digitalschnittstellen über die das digitalisierte ZF-Signal übertragen wird meist pro Kanal aus einem differentiellen Adernpaar besteht, müssen je nach FPGA diskrete Leitungsabschlusswiderstände vorgesehen werden. Diese haben meist den Wert von 100 Ohm.

Ein weiteres Bauelement das in vorteilhafter Weise verwendet werden kann ist ein Verstärker (oder mehrere davon) mit integriertem Splitter für Niederfrequenzsignale, die ausgehend vom Master, den Start einer Messung signalisieren. Der Master sendet dieses Signal aus und verteilt es an alle Slaves. Wichtig dabei ist, dass die Leitungen in etwa die gleiche Länge aufweisen, damit es keine Zeitversätze in den einzelnen Radarchips gibt.

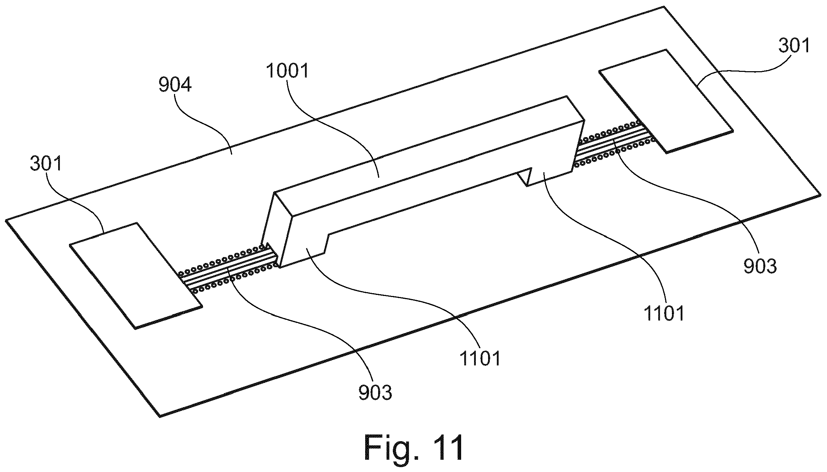

Da auf diese Art und Weise eine größere Menge an Radarchips kaskadiert werden kann, kann es vorkommen, dass die Ausgangsstufe des LO-Signals nicht ausreichend Ausgangsleistung liefert um alle Radarchips zu treiben. Problematisch an der Verteilung des LO-Signals auf der Hochfrequenzleitung 401 ist, dass Hochfrequenzleitungen eine nicht zu vernachlässigbare Streckendämpfung aufweisen. Da die Radarchips 301 auf der Platine 904 meist mehrere Zentimeter (Größenordnung: 5-10 cm) räumlich voneinander getrennt sind, müssen die Hochfrequenzleitungen 401, die das LO-Signal führen mindestens genau so lang sein. Eine typische Mikrostreifenleitung auf einem Standard-Hochfrequenz-Substrat kann eine Dämpfung von 0,5 bis 2 dB / cm aufweisen. Dies ist hauptsächlich substrat- und frequenzabhängig. Hohlleiter hingegen können so aufgebaut werden, dass sie eine weitaus geringere Streckendämpfung besitzen. Aus diesem Grund macht es Sinn, nachdem das LO-Signal auf die Platine 904 mittels einer Mikrostreifenleitung ausgekoppelt wurde, das Signal in einen Hohlleiter einzukoppeln um weniger Verluste auf der Wegstrecke zum benachbarten Chip einzufahren (schematisch dargestellt in Figur 11).

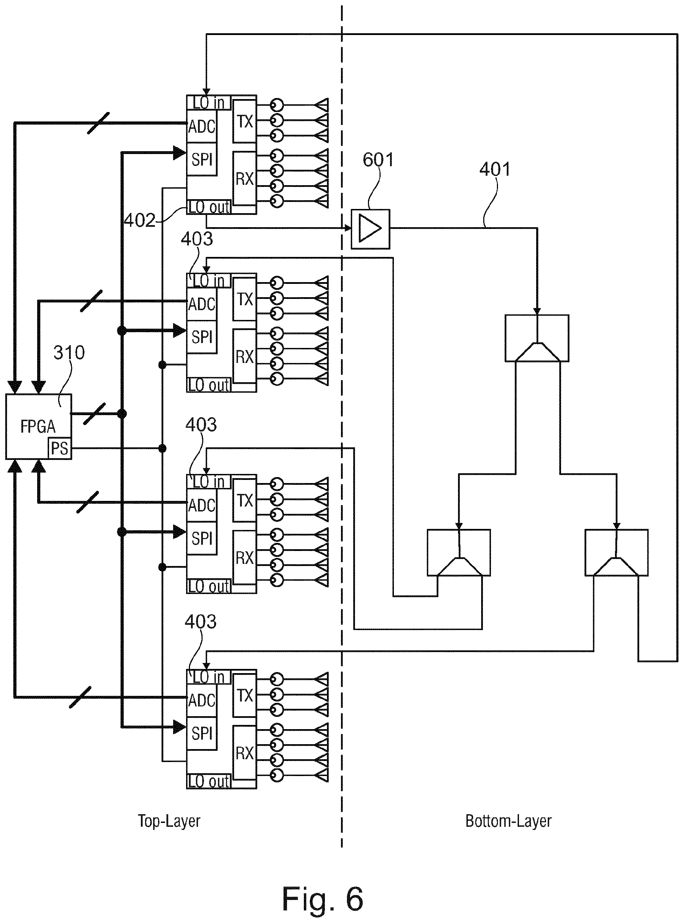

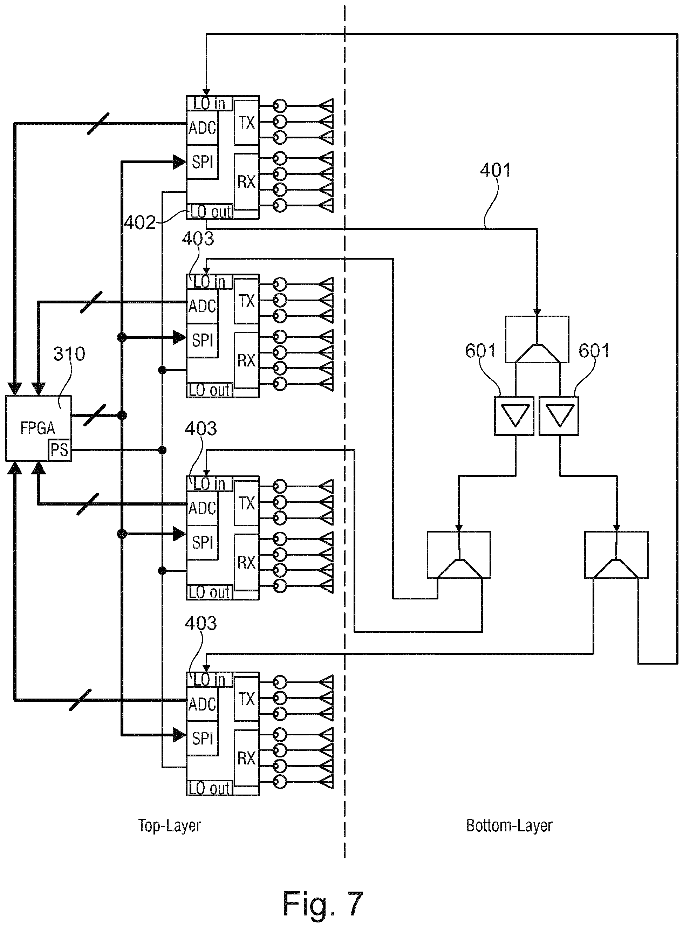

Eine weitere Möglichkeit ist es, indem ein oder mehrere externe Hochfrequenzverstärker 601 eingesetzt werden um die HF-Leistung des LO-Signals auf der Hochfrequenzleitung 401 zu verstärken (Figur 6 und 7). In vorteilhafter Weise haben diese Verstärker eine geringe Rauschzahl (Noise Figure), da diese direkt auf die Systemperformance Auswirkung hat. Deshalb werden hierfür rauscharme Verstärker (engl. Low Noise Amplifiers, LNAs) vorgeschlagen.

Die LNAs sind aktive Bauelemente mit separater Spannungsversorgung. In vorteilhafter Weise werden diese zwischen den Radarframes und/oder in Sendepausen abgeschaltet um Energie zu sparen und um eine zu starke Erwärmung des Geräts zu vermeiden.

Weiterhin muss darauf geachtet werden, dass die LNAs in ihrem linearen Bereich betrieben werden, was bedeutet, dass die Eingangsleistung des Hochfrequenzsignals nicht zu groß ist. Ist dies der Fall kann es zu Signalverzerrungen kommen. Technologiebedingt liegen typische Ausgangsleistungen von Halbleiterbauelementen bei 80 GHz zwischen 8 und 15 dBm, ohne dass es zu wesentlichen Signalverzerrungen kommt.

Würde ein Hochfrequenzverstärker 601 mit 20 dB Gain mit einem Hochfrequenzsignal mit einer Leistung von 15 dBm gespeist werden, ergäbe sich theoretisch eine Ausgangsleistung von 35 dBm. Da der Hochfrequenzverstärker 601 dann aber nicht mehr in seinem linearen Bereich arbeiten würde, würde es zu unerwünschten Signalverzerrungen kommen. Deshalb muss das LO-Signal zunächst in einen Leistungsbereich gebracht werden, damit der Hochfrequenzverstärker 601 in seinem linearen Bereich arbeiten kann. Es gibt die Möglichkeit die LO-Ausgangsleistung der Radarchips 301 zu parametrieren und somit zu dämpfen. Ebenfalls kann eine lange Hochfrequenzleitung die Ausgangsleistung ebenfalls dämpfen.

Möglicherweise können die Hochfrequenzverstärker auch erst eingesetzt werden, nachdem das LO-Signal mithilfe eines Hochfrequenzleistungsteilers geteilt und somit in der Leistung niedriger gemacht wurde. Das ist der Fall, wenn mehrere Slaves 301b zum Einsatz kommen oder wenn je nach Radarchip 301 das LO-Signal wieder in den Master 301a zurückgeführt werden muss.

Es können mehrere Verstärker eingesetzt werden, wie in Figur 7 zu sehen ist. Da ein Verstärker ebenfalls eine endliche Signaldurchlaufzeit hat, werden in vorteilhafter Weise die Verstärker so platziert, dass sich auf allen Leitungen im Wesentlichen die gleiche Signallaufzeit einstellt.

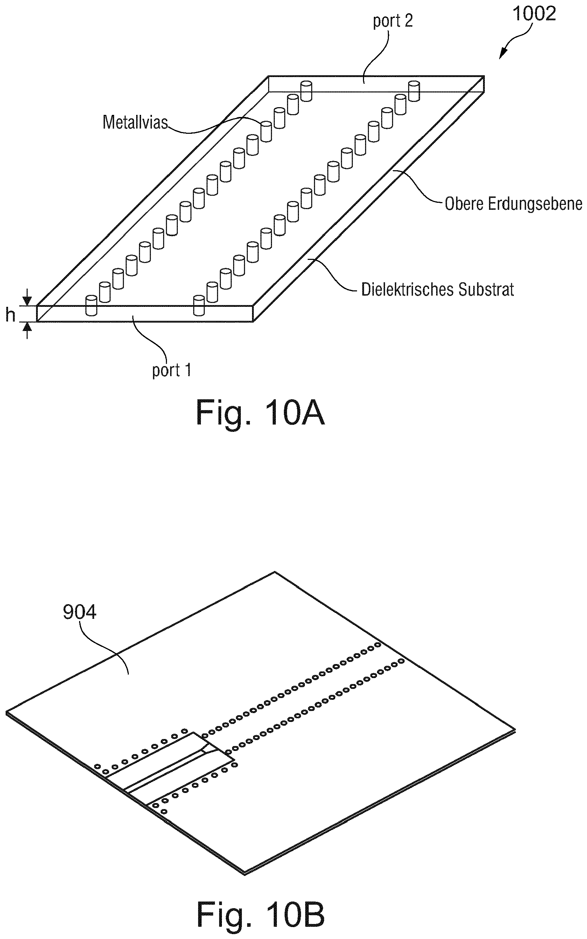

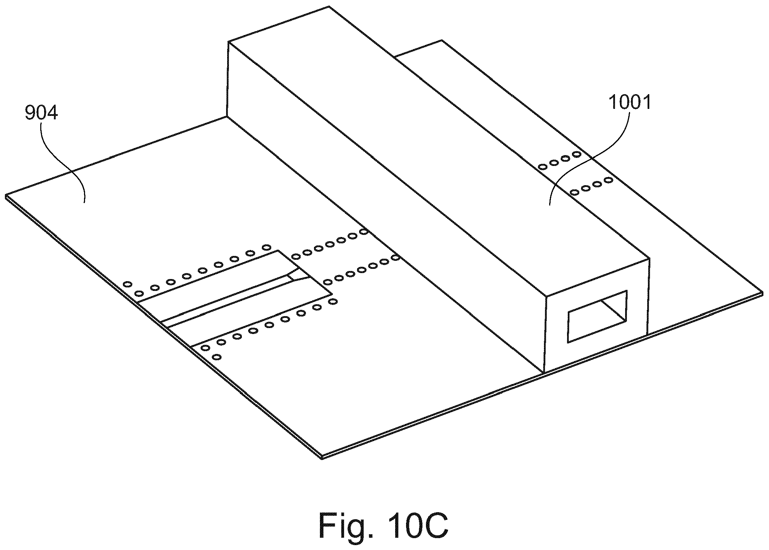

Da es sich beim LO-Signal um ein Hochfrequenzsignal handelt, werden in vorteilhafter Weise Hohlleiter, Mikrostreifenleiter 903 und/oder SIW-Leitungen (Substrate Integrated Waveguide) 1002 (Figur 10) verwendet. Ebenfalls werden zur Aufsplittung der Leitung in vorteilhafter Weise Leistungsteiler 501 (z.B. Wilkinson-Divider) und/oder Koppler 501 (z.B. Rat-Race-Koppler oder Magic T 1401) verwendet.

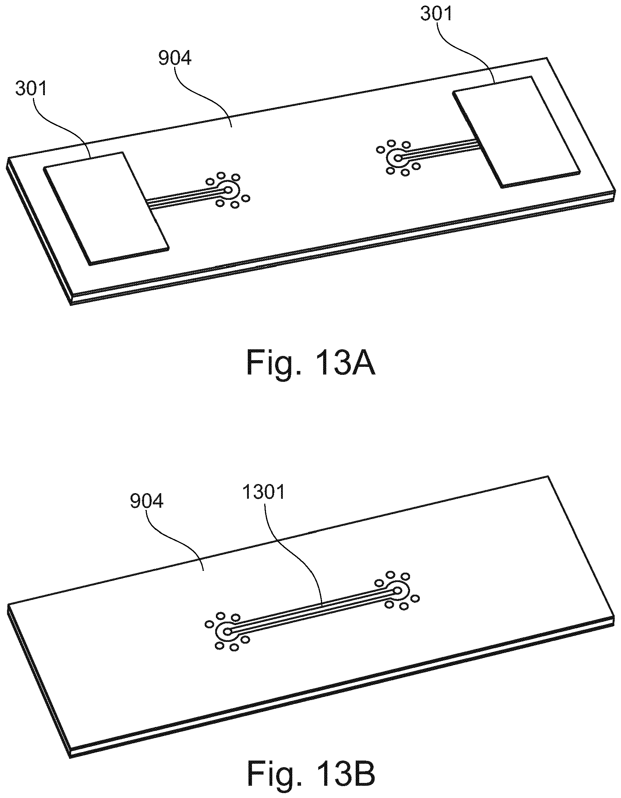

In vorteilhafter Weise werden die Radarchips 301 auf der einen Seite der Platine 904 platziert und die Hochfrequenzleitung 1301, die den größten Teil der Hochfrequenzleitungsanordnung 401 darstellen kann, ist auf der anderen Seite der Platine angeordnet, so dass die Aufsplittung und Verteilung des LO-Signals auf der anderen Seite der Platine 904 geschieht, so wie in den Figuren 5 bis 7 und ebenfalls in den Figuren 13A und 13B gezeigt. Die Ursache hierfür wird im Folgenden dargestellt.

Die Radarchips besitzen meist neun oder zehn Signaleingänge und Signalausgänge deren Frequenzbereich im zweistelligen Gigahertzbereich liegt. Bei der Kaskadierung der Radarchips müssen neben den Leitungen zu den Sende- und Empfangsantennen noch die LO-Signale von Chip zu Chip geroutet werden. Durch diese Vielzahl an Signalleitungen sind Kreuzungen von Signalen oftmals unausweichlich.

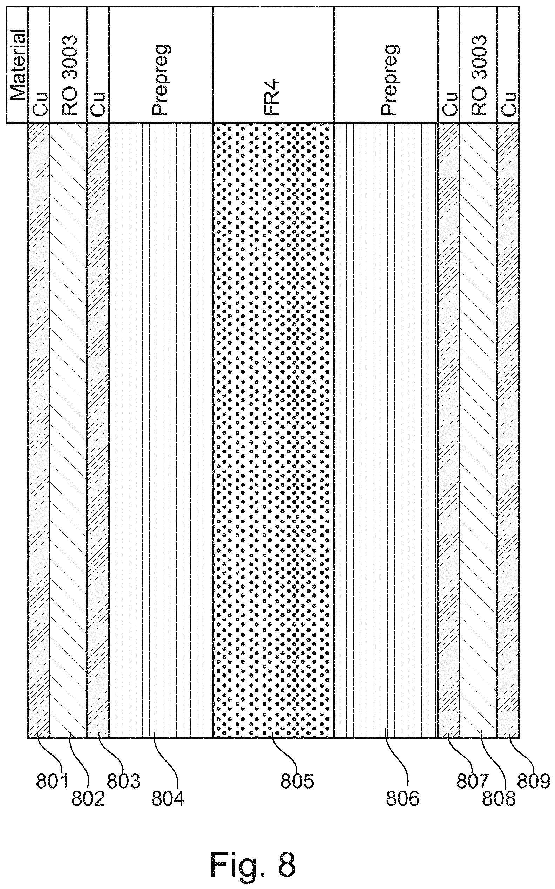

Da jedoch Kreuzungen von Signalleitungen auf einer Platine 904 nicht möglich sind, werden die Signale üblicherweise mit Vias in andere innenliegende Platinenebenen (Innenlagen) 803, 807 geleitet und dort aneinander vorbeigeführt. Ein typischer Platinenlagenaufbau ist in Figur 8 zu sehen, wobei mehrere Substrate mit einer Klebefolie 804, 806 zusammengeklebt werden. Meist sind Innenlagen von Platinen 904 jedoch Standardsubstratmaterialien 804, 805, 806 und nicht für Hochfrequenzsignale geeignet. Aus Kosten- und Stabilitätsgründen werden nämlich oftmals nur eine oder beide der äußersten Substratlagen 802, 808 einer Platine 904 aus speziellem für die Hochfrequenztechnik optimiertem Substratmaterial (Beispielsweise Rogers RO3003) aufgebaut. Hochfrequenzsubstrate sind in der Regel weich und müssen bei hohen Frequenzen sehr dünn ausgeführt werden, z.B. mit 127µm.

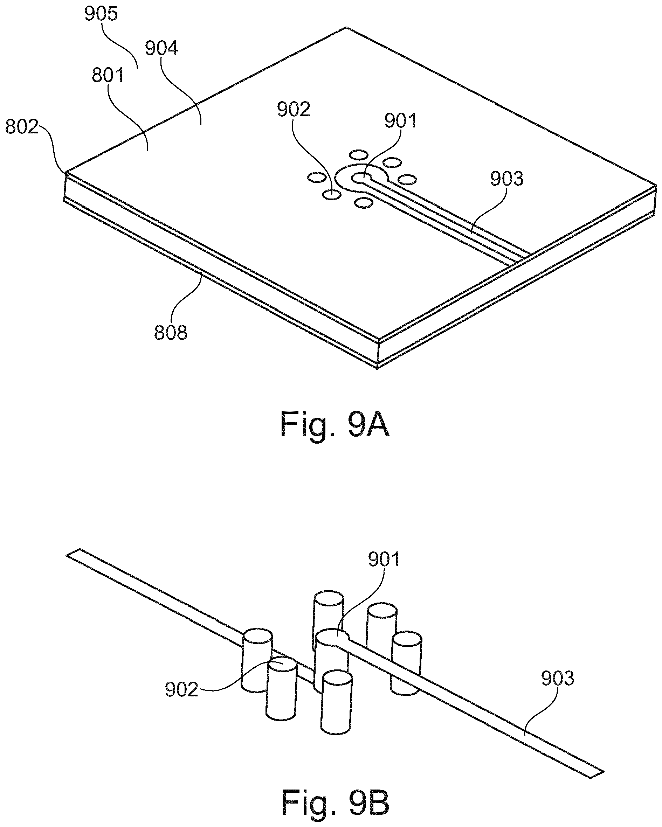

Aus diesen Gründen wird vorgeschlagen mit speziellen Leitungsstrukturen und Via-Anordnungen das LO-Signal von der chipseitigen Platinenebene auf die Rückseite zu führen, dort zu splitten, ggf. zu verstärken und zu verteilen und wieder auf die chipseitige Platinenebene aufzutauchen. Solche speziellen Leitungsstrukturen und Via-Anordnungen sind in Figuren 9A und 9B zu sehen (Figur 9B zeigt die Leitung und Vias ohne die Substratmaterialien und Kupferflächen). Dabei werden um das Hauptvia 901 weitere Nebenvias 902 in einem konstanten Radius platziert und bilden so eine Art koaxiale Leiterplattendurchführung. Viadurchmesser und Abstand zum Hauptvia bestimmen maßgeblich die Impedanz der Durchführung und muss auf den verwendeten Frequenzbereich von beispielsweise 40 GHz angepasst werden.

Eine alternative Möglichkeit die LO-Signale ohne Kreuzung der Leitungen zu routen ist, das Signal in einen Hohlleiter oder ein Koaxialkabel einzukoppeln und die Hohlleiter bzw. Koaxialkabel so aufzubauen, dass die Leitungen aneinander vorbeiführen. Um beispielsweise in einen Hohlleiter einzukoppeln muss ein Übergang von Mikrostreifenleitung auf Hohlleiter 1101 verwendet werden.

Ein ebenfalls nützlicher Leitungstyp ist der Substrate Integrated Waveguide (SIW) (Figur 10A). Dieser Leitungstyp wird in vorteilhafter Weise dann verwendet, wenn beispielsweise ein Hohlleiter 1001 direkt auf einer Leiterkarte/Platine 904 aufliegt auf der ein LO-/HF-Signal mittels Mikrostreifenleitung unter dem Hohlleiter hindurchgeroutet werden muss. Da der Hohlleiter meist aus einem Metall besteht, würde er die Mikrostreifenleitung kurzschließen, was eine Signalübertragung unmöglich macht. Hier bietet der SIW Vorteile, da dieser auf der Platinenoberseite eine reine Metallfläche aufweist und es keine Rolle spielt ob ein Hohlleiter darüber liegt (siehe Figur 10C). Ein Übergang von Mikrostreifenleitungstechnik auf SIW ist in Abbildung 10B gezeigt.

Anschließend muss das Signal wieder auf die Platine 904 in eine Mikrostreifenleitung eingekoppelt werden um in den Radarchip geroutet werden zu können.

Auszeichnend für Radarfüllstandmessgeräte sind robuste Antennenvorrichtungen, die bei rauen Prozessbedingungen, wie hohen und niedrigen Drücken, hohen und tiefen Temperaturen, Schmutz, Staub, Feuchtigkeit, Nebel, etc. noch funktionieren. Hinzu kommt, dass die Antennen ebenfalls die Elektronik vor obigen Einflüssen schützen müssen und oft so konstruiert sind, dass sie ebenfalls sicherheitskritische Aspekte wie Explosionsschutz erfüllen.

So kann auch bei topologieerfassenden Radarfüllstandmessgeräten diese Eigenschaft implementiert sein. Anders als bei Radargeräten in der Automobilindustrie, bei denen solche Anforderungen nicht so hoch sind, werden in der Prozessmesstechnik häufig Hohlleiter und Hornstrahler verwendet.

Darüber hinaus ist es bei Systemen zur digitalen Strahlformung vorteilhaft, wenn ein oder mehrere Antennenelemente einen Abstand ≤ λ/2 aufweisen, wobei λ die Wellenlänge des Sendesignals bezeichnet. Für solche Fälle müssen spezielle Hohlleitereinkopplungen 302 verwendet werden, um das Signal von einer Leiterkarte in eine (Horn-)Antenne 303 einzukoppeln.

Ein weiteres Problem topologieerfassenden Radarfüllstandmessgeräten mit kaskadierten Radarchips ist es, dass die oben beschriebenen Antennen nur in bestimmten Mustern angeordnet werden dürfen. Ein vorteilhaftes Muster wäre eine "T-" oder "L-förmige" Anordnung der Antennenelemente. Um bei den Hochfrequenzsignalen große Leitungslängen zu vermeiden, wird vorgeschlagen, die Radarchips auf der Platinen-Ober- und Unterseite zu platzieren damit die Leitungslängen von Radarchip zu Hohlleitereinkopplung für alle HF-Signale etwa gleich lang ist.

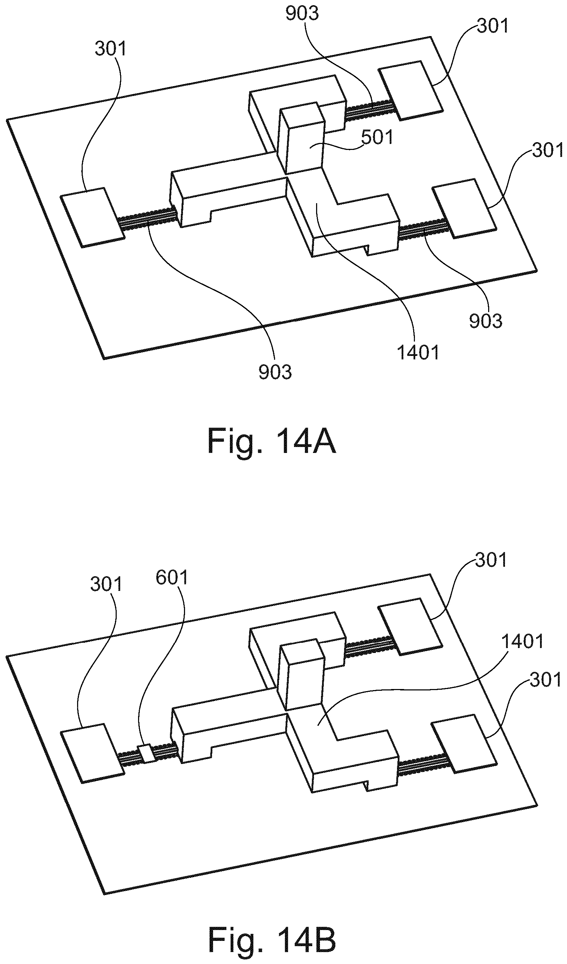

Fig. 14A zeigt eine Hochfrequenzleitungsanordnung, die das Hochfrequenzsignal von der ersten Synchronisationsschaltung 402 (vgl. Fig. 5) des ersten Radarchips zu den entsprechenden Synchronisationsschaltungen 403 der Slave-Chips leitet, so dass der Master-Chip die Slave-Chips synchronisieren kann.

Die platinengebundene Leitung 903 mündet in eine Hohlleitereinkopplung, so dass das Hochfrequenzsignal daran anschließend von dem Hohlleiter 1401 weitergeführt werden kann. Im Hohlleiter 1401 ist ein Hochfrequenzleistungsteiler 501 vorgesehen, der das Hochfrequenzsignal auf zwei Hohlleiter aufteilt, die dann jeweils in eine platinengebundene Hochfrequenzleitung 903 münden, die das Hochfrequenzsignal an den jeweiligen Radarchip weiterleiten.

Im Vergleich zur Fig. 14A ist in der Ausführungsform gemäß Fig. 14B in der ersten platinengebundenen Leitung ein Hochfrequenzverstärker 601 vorgesehen, um das Hochfrequenzsignal zu verstärken, bevor es in den Hohlleiter 1401 eingekoppelt wird.

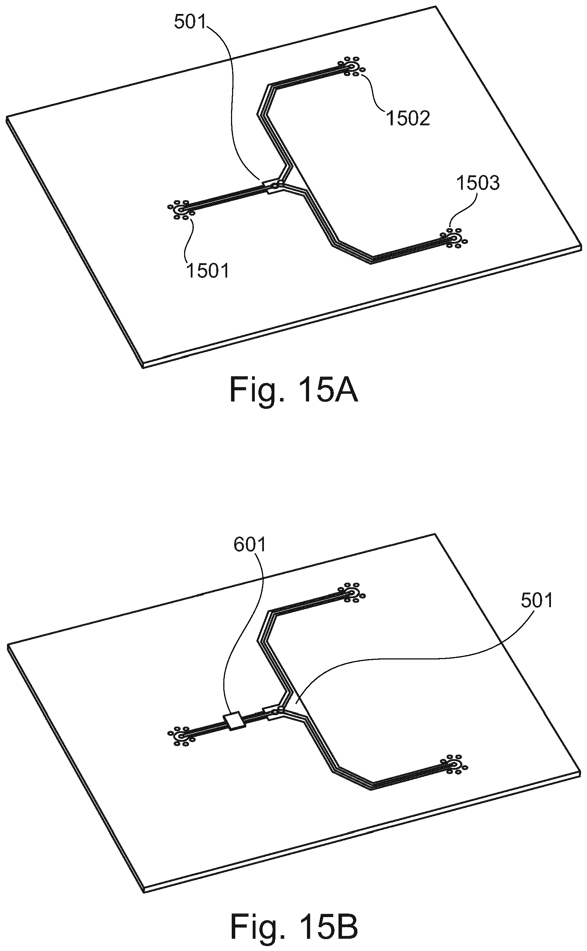

Fig. 15A zeigt eine weitere Ausführungsform einer Hochfrequenzleitungsanordnung auf der Oberseite der Platine mit einem Leistungsteiler 501. Der Anfangspunkt 1501 und die Endpunkte 1502, 1503 weisen jeweils eine Via auf, wie sie in den Fig. 9A und 9B näher gezeigt ist.

Fig. 15B entspricht der Ausführungsform der Fig. 15A und weist darüber hinaus einen Verstärker 601 vor dem Leistungsteiler 501 auf.

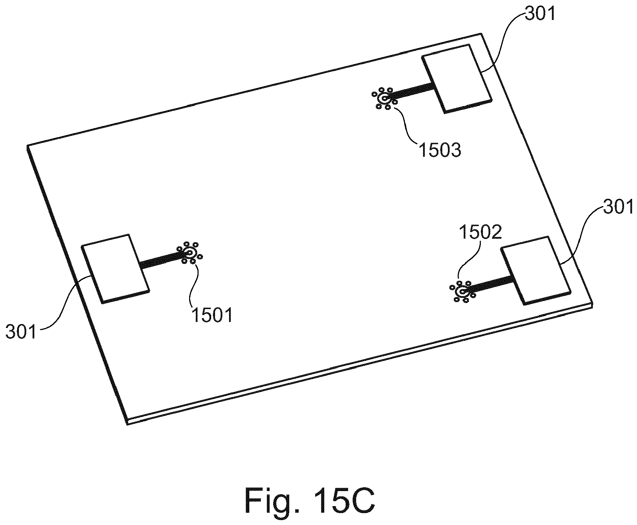

Fig. 15C zeigt die Unterseite der Platinen der Fig. 15A und 15B, auf welcher die Radarchips 301 und die anderen Synchronisationsschaltungen angeschlossene Leitungen zu sehen sind, die in die in den Fig. 15A und B gezeigten Vias münden.

Ein Kerngedanke der Erfindung kann darin gesehen werden, dass ein die Topologie der Füllgutoberfläche erfassendes Radarfüllstandmessgerät 101 bereitgestellt wird, welches aus mehreren integrierten Radarchips 301 besteht oder diese zumindest aufweist, wobei die Radarchips 301 mit einem Hochfrequenzsignal (Lokaloszillatorsignal), das von einem Radarchip 301a generiert und auf einer Hochfrequenzleitung 401 geführt wird, miteinander synchronisiert werden, wobei die Radarchips platinenoberseitig platziert werden und das Lokaloszillatorsignal, nachdem es auf eine Mikrostreifenleitung 903 ausgekoppelt wurde, mittels eines Koaxial-Vias 905 auf die Platinenrückseite geführt wird.

Ergänzend sei daraufhingewiesen, dass "umfassend" und "aufweisend" keine anderen Elemente oder Schritte ausschließt und die unbestimmten Artikel "eine" oder "ein" keine Vielzahl ausschließen. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkungen anzusehen.

## Patentansprüche

1. Radarfüllstandmessgerät (101) zur Füllstandmessung oder zur Erfassung der Topologie einer Füllgutoberfläche in einem Behälter, aufweisend:
eine Platine (904) mit einer ersten Schicht (801) und einer zweiten Schicht (809);
einen ersten Radarchip (301a) und einen zweiten Radarchip (301b), die jeweils auf der ersten Schicht angeordnet sind;
wobei der erste Radarchip (301a) als Master eine erste Synchronisationsschaltung (402) aufweist, welche zur Erzeugung eines Hochfrequenzsignals eingerichtet ist;
wobei der zweite Radarchip (301b) als Slave eine zweite Synchronisationsschaltung (403) aufweist;
eine Hochfrequenzleitungsanordnung (401), eingerichtet zur Übertragung des Hochfrequenzsignals von der ersten Synchronisationsschaltung an die zweite Synchronisationsschaltung zur Synchronisation der beiden Radarchips;
wobei die Hochfrequenzleitungsanordnung eine erste Leiterbahn (903) auf der ersten Schicht, eine zweite Leiterbahn (903) auf der ersten Schicht und eine dazwischen angeordnete Hochfrequenzleitung (1301, 1001) auf der zweiten Schicht aufweist, die über jeweils ein Via (901) mit der ersten und der zweiten Leiterbahn verbunden ist.

2. Radarfüllstandmessgerät (101) nach Anspruch 1,
wobei die Hochfrequenzleitung (1301, 1001, 1002) eine dritte Leiterbahn (1301) aufweist.

3. Radarfüllstandmessgerät (101) nach einem der vorhergehenden Ansprüche, wobei die Hochfrequenzleitung (1301, 1001) einen Hohlleiter (1001, 1002) aufweist.

4. Radarfüllstandmessgerät (101) nach einem der vorhergehenden Ansprüche, wobei die erste Leiterbahn (903) und die zweite Leiterbahn (903) Mikrostreifenleitungen sind.

5. Radarfüllstandmessgerät (101) nach einem der vorhergehenden Ansprüche, wobei die dritte Leiterbahn (903) eine Mikrostreifenleitung ist.

6. Radarfüllstandmessgerät (101) nach einem der vorhergehenden Ansprüche, wobei die Hochfrequenzleitungsanordnung zur Übertragung des Hochfrequenzsignals zwei oder mehr unterschiedliche Leitungstypen (903, 1001, 1002, 1301), insbesondere eine Mikrostreifenleitung, einen Rechteckhohlleiter, einen Rundhohlleiter, einen Koaxialleiter, einen Substrate Integrated Waveguide und/oder eine Koplanarleitung, aufweist, die seriell zueinander angeordnet sind.

7. Radarfüllstandmessgerät (101) nach einem der vorhergehenden Ansprüche, wobei die Hochfrequenzleitungsanordnung (401) mithilfe eines Hochfrequenzleistungsteilers (501) gesplittet ist, um mehrere Radarchips (301b) zu synchronisieren.

8. Radarfüllstandmessgerät (101) nach Anspruch 7,
wobei die beiden von dem Hochfrequenzleistungsteiler (501) ausgehenden Leitungen dieselbe Signallaufzeit aufweisen, bis das gesplittete Hochfrequenzsignal die Synchronisationsschaltung (403) des entsprechenden Radarchips (301b) erreicht.

9. Radarfüllstandmessgerät (101) nach einem der vorhergehenden Ansprüche, weiter aufweisend einen Hochfrequenzverstärker (601), der in der Hochfrequenzleitungsanordnung angeordnet ist und eingerichtet ist zur Verstärkung des Hochfrequenzsignals.

10. Radarfüllstandmessgerät (101) nach einem der vorhergehenden Ansprüche, wobei das Hochfrequenzsignal im Verhältnis zum Sendesignal ein um einen ganzzahligen Faktor geteiltes Hochfrequenzsignal ist.

11. Radarfüllstandmessgerät (101) nach einem der Ansprüche 9 oder 10,
wobei der Hochfrequenzverstärker (601) einen Nutzfrequenzbereich von über 30 GHz aufweist.

12. Radarfüllstandmessgerät (101) nach einem der vorhergehenden Ansprüche, wobei auf dem ersten und dem zweiten Radarchip (301a, 301b) jeweils ein Analog / Digitalwandler integriert ist.

13. Radarfüllstandmessgerät (101) nach einem der vorhergehenden Ansprüche, eingerichtet zur Erfassung der Topologie eines Mediums in einem Behälter.

14. Radarfüllstandmessgerät (101) nach einem der vorhergehenden Ansprüche, wobei der erste Radarchip (301a) und der zweite Radarchip (301b) jeweils einen oder mehrere Sendekanäle (307) zum Abstrahlen jeweils eines Sendesignals und einen oder mehrere Empfangskanäle (308) zum Empfangen jeweils der an der Füllgutoberfläche reflektierten Sendesignale aufweisen.

15. Radarfüllstandmessgerät (101) nach einem der vorhergehenden Ansprüche, wobei das Füllstandmessgerät (100) als FMCW Füllstandmessgerät ausgeführt ist.

16. Radarfüllstandmessgerät (101) nach einem der vorhergehenden Ansprüche, wobei sämtliche von dem Radarfüllstandmessgerät erfassten Messsignale ausschließlich auf der ersten Schicht (801) verarbeitet werden.

## Claims

1. Radar fill level measurement device (101) for fill level measurement or for recording the topology of a filling material surface in a container, comprising:
a printed circuit board (904) having a first layer (801) and a second layer (809);
a first radar chip (301a) and a second radar chip (301b) that are each arranged on the first layer;
wherein the first radar chip as a master comprises a first synchronization circuit (402) configured to generate a high-frequency signal;
wherein the second radar chip as a slave comprises a second synchronization circuit (403);
a high-frequency line arrangement (401) that is configured to transmit the high-frequency signal from the first synchronization circuit to the second synchronization circuit for synchronizing the two radar chips;
wherein the high-frequency line arrangement comprises a first conductive track (903) on the first layer, a second conductive track (903) on the first layer and a high-frequency line (1301, 1001) arranged therebetween on the second layer and connected, by means of a first via (905), to the first conductive track and to the second conductive track.

2. Radar fill level measurement device (101) according to claim 1,
wherein the high-frequency line (1301, 1001, 1002) comprises a third conductive track (1301).

3. Radar fill level measurement device (101) according to either of the preceding claims,
wherein the high-frequency line (1301, 1001) comprises a waveguide (1001, 1002).

4. Radar fill level measurement device (101) according to any of the preceding claims,
wherein the first conductive track (903) and the second conductive track (903) are microstrip lines.

5. Radar fill level measurement device (101) according to any of the preceding claims,
wherein the third conductive track (903) is a microstrip line.

6. Radar fill level measurement device (101) according to any of the preceding claims,
wherein the high-frequency line arrangement configured to transmit the high-frequency signal comprises two or more different types of line (903, 1001, 1002, 1301), particularly a microstrip line, a rectangular waveguide, a round waveguide, a coaxial line, a substrate integrated waveguide, and/or a coplanar line, which are arranged in series with one another.

7. Radar fill level measurement device (101) according to any of the preceding claims,
wherein the high-frequency line arrangement (401) is split by means of a high-frequency power divider (501) in order to synchronize a plurality of radar chips (301b).

8. Radar fill level measurement device (101) according to claim 7,
wherein the two lines that begin at the high-frequency power divider (501) have the same signal propagation time until the split high-frequency signal reaches the synchronization circuit (403) of the corresponding radar chip (301b).

9. Radar fill level measurement device (101) according to any of the preceding claims,
further comprising a high-frequency amplifier (601) that is arranged in the high-frequency line arrangement and is configured to amplify the high-frequency signal.

10. Radar fill level measurement device (101) according to any of the preceding claims,
wherein the high-frequency signal is a high-frequency signal that is divided by an integer factor with respect to the transmission signal.

11. Radar fill level measurement device (101) according to either claim 9 or 10,
wherein the high-frequency amplifier (601) has a useful frequency range of above 30 GHz.

12. Radar fill level measurement device (101) according to any of the preceding claims,
wherein an analog-to-digital converter is integrated in the first and the second radar chip (301a, 301b).

13. Radar fill level measurement device (101) according to any of the preceding claims, configured to record the topology of a medium in a container.

14. Radar fill level measurement device (101) according to any of the preceding claims,
wherein the first radar chip (301a) and the second radar chip (301b) each comprise one or more transmission channels (307) configured to emit one transmission signal in each case, and one or more reception channels (308) configured to receive the transmission signals reflected on the filling material surface.

15. Radar fill level measurement device (101) according to any of the preceding claims,
wherein the fill level measurement device (100) is configured as an FMCW fill level measurement device.

16. Radar fill level measurement device (101) according to any of the preceding claims,
wherein all the measurement signals received by the radar fill level measurement device are processed only on the first layer (801).

## Revendications

1. Appareil de mesure de niveau de remplissage par radar (101) pour la mesure de niveau de remplissage ou pour la détection de la topologie d'une surface d'un produit de remplissage dans un récipient, présentant :
une carte de circuit imprimé (904) ayant une première couche (801) et une deuxième couche (809) ;
une première puce radar (301a) et une deuxième puce radar (301b) disposées chacune sur la première couche ;
la première puce radar (301a) présentant en tant que maître un premier circuit de synchronisation (402) conçu pour produire un signal à haute fréquence ;
la deuxième puce radar (301b) présentant en tant qu'esclave un deuxième circuit de synchronisation (403) ;
un agencement de lignes à haute fréquence (401) conçu pour transmettre le signal à haute fréquence du premier circuit de synchronisation au deuxième circuit de synchronisation pour synchroniser les deux puces radar ;
l'agencement de lignes à haute fréquence présentant une première piste conductrice (903) sur la première couche, une deuxième piste conductrice (903) sur la première couche, et
une ligne à haute fréquence (1301, 1001) interposée sur la deuxième couche et connectée respectivement aux première et deuxième pistes conductrices par un trou d'interconnexion (901) .

2. Appareil de mesure de niveau de remplissage par radar (101) selon la revendication 1,
dans lequel la ligne à haute fréquence (1301, 1001, 1002) présente une troisième piste conductrice (1301).

3. Appareil de mesure de niveau de remplissage par radar (101) selon l'une des revendications précédentes,
dans lequel la ligne à haute fréquence (1301, 1001) présente un guide d'ondes (1001, 1002).

4. Appareil de mesure de niveau de remplissage par radar (101) selon l'une des revendications précédentes,
dans lequel la première piste conductrice (903) et la deuxième piste conductrice (903) sont des lignes à microruban.

5. Appareil de mesure de niveau de remplissage par radar (101) selon l'une des revendications précédentes,
dans lequel la troisième piste conductrice (903) est une ligne à microruban.

6. Appareil de mesure de niveau de remplissage par radar (101) selon l'une des revendications précédentes,
dans lequel l'agencement de lignes à haute fréquence pour la transmission du signal à haute fréquence présente deux ou plusieurs types de lignes (903, 1001, 1002, 1301) différents, en particulier une ligne à microruban, un guide d'ondes rectangulaire, un guide d'ondes circulaire, une ligne coaxiale, un guide d'ondes intégré au substrat et/ou une ligne coplanaire, qui sont disposés en série les uns par rapport aux autres.

7. Appareil de mesure de niveau de remplissage par radar (101) selon l'une des revendications précédentes,
dans lequel l'agencement de lignes à haute fréquence (401) est divisé au moyen d'un diviseur de puissance haute fréquence (501) pour synchroniser plusieurs puces radar (301b) .

8. Appareil de mesure de niveau de remplissage par radar (101) selon la revendication 7,
dans lequel les deux lignes partant du diviseur de puissance haute fréquence (501) présentent le même temps de propagation de signal jusqu'à ce que le signal à haute fréquence divisé atteigne le circuit de synchronisation (403) de la puce radar correspondante (301b).

9. Appareil de mesure de niveau de remplissage par radar (101) selon l'une des revendications précédentes,
présentant en outre un amplificateur de haute fréquence (601) qui est disposé dans l'agencement de lignes à haute fréquence et est conçu pour amplifier le signal à haute fréquence.

10. Appareil de mesure de niveau de remplissage par radar (101) selon l'une des revendications précédentes,
dans lequel le signal à haute fréquence est un signal à haute fréquence divisé par un facteur entier par rapport au signal d'émission.

11. Appareil de mesure de niveau de remplissage par radar (101) selon l'une des revendications 9 ou 10,
dans lequel l'amplificateur de haute fréquence (601) présente une gamme de fréquences utiles supérieure à 30 GHz.

12. Appareil de mesure de niveau de remplissage par radar (101) selon l'une des revendications précédentes,
dans lequel un convertisseur analogique/numérique est intégré sur chacune des première et deuxième puces radar (301a, 301b).

13. Appareil de mesure de niveau de remplissage par radar (101) selon l'une des revendications précédentes,
lequel est conçu pour détecter la topologie d'un milieu dans un récipient.

14. Appareil de mesure de niveau de remplissage par radar (101) selon l'une des revendications précédentes,
dans lequel la première puce radar (301a) et la deuxième puce radar (301b) présentent chacune un ou plusieurs canaux d'émission (307) pour émettre un signal d'émission respectif et un ou plusieurs canaux de réception (308) pour recevoir les signaux d'émission respectifs réfléchis sur la surface du produit de remplissage.

15. Appareil de mesure de niveau de remplissage par radar (101) selon l'une des revendications précédentes,
dans lequel l'appareil de mesure de niveau de remplissage (100) est réalisé sous la forme d'un appareil de mesure de niveau FMCW.

16. Appareil de mesure de niveau de remplissage par radar (101) selon l'une des revendications précédentes,
dans lequel tous les signaux de mesure détectés par l'appareil de mesure de niveau de remplissage par radar sont traités exclusivement sur la première couche (801).
